# EUROPEAN PATENT SPECIFICATION

(11) **EP 0 721 201 B1**
(45) Date of publication and mention of the grant of the patent: **26.08.1998**
(21) Application number: 95120059.1
(22) Date of filing: 19.12.1995
(51) Int. Cl.: H01J 37/244

(54) **System for high resolution imaging and measurement of topographic and material features on a specimen**
System zur Hochauflösungsbildgebung und Messung von topographischen Characteristiken und Materialcharakteristiken einer Probe
Equipement pour l'imagerie à haute résolution et pour la mesure de caractéristiques topographiques et matérielles d'un échantillon

(30) Priority: 19.12.1994 US 359297
(43) Date of publication of application: 10.07.1996
(73) Proprietor: OPAL TECHNOLOGIES LTD., 70451 Nes Ziona (IL)
(72) Inventor: Litman, Alon, Nes Ziona (IL); Goldenstein, Alexander, Holon (IL); Rogers, Steven R., D.N.Emek Sorek (IL)
(74) Representative: Modiano, Guido, Dr.-Ing.

(56) References cited:
- EP-A- 0 464 917
- EP-A- 0 661 727
- WO-A-90/04261
- ELEKTRONIK, vol. 40, no. 15, 23 July 1991, pages 63-66, XP000243105 BRUEGEL M: "E-BEAM-PROBER: ELEKTRONENSTRAHL ALS TASTSPITZE"
- PATENT ABSTRACTS OF JAPAN vol. 007, no. 260 (P-237) 18 November 1983 & JP-A-58 142 285 (NIPPON DENSHI KK) 24 August 1983
- JOURNAL OF VACUUM SCIENCE AND TECHNOLOGY: PART B, vol. 9, no. 6, 1 November 1991, pages 3590-3595, XP000268569 LEE K L ET AL: "LOW VOLTAGE BACKSCATTERED ELECTRON COLLECTION FOR PACKAGE SUBSTRATES AND INTEGRATED CIRCUIT INSPECTION"

## Description

### FIELD AND BACKGROUND OF THE INVENTION

The present invention relates to particle beam imaging and measurement equipment in general and in particular to automated in-process scanning electron beam equipment for performing high resolution imaging and measurement of semiconductor wafers having topographic and/or material features.

As integrated circuits are fabricated with features smaller than the wavelength of visible light, electron beam imaging has been established as the technology of choice for process development and quality assurance, as described by M. H. Bennett and G. E. Fuller in an article entitled "In-Process Inspection and Metrology of Semiconductor Wafers with the Use of an Automated Low-Voltage SEM," Microbeam Analysis 1986, pp. 649-652.

When a particle beam impinges on a specimen, there is a release of electrons from the specimen. The electrons are broadly divided into two categories: electrons with energies below 50 electron volts which are referred to as secondary electrons and electrons with energies equal to or greater than 50 electron volts which are referred to as backscattered electrons.

As described by L. Reimer in a book entitled "Image Formation in Low-Voltage Scanning Electron Microscopy", SPIE Optical Engineering Press, 1993, secondary electrons reveal topographic details of the specimen surface whereas, backscattered electrons discriminate between different materials included in the specimen.

U.S. Patent 4,941,980 to Halavee et al discloses an apparatus and method for measuring a topographic feature employing four electron detectors, spaced evenly in a circle around an electron column, which directs a primary electron beam at normal incidence to a specimen. To attract the secondary electrons emitted by the specimen, a positive charge is applied simultaneously to two oppositely disposed electron detectors. As the primary beam is scanned over the surface of the specimen, the signals from the two charged detectors are combined so as to make a cross-sectional profile of topographic features on the specimen. By alternating between the two pairs of oppositely placed detectors, profiles can be obtained along two orthogonal directions. In this prior art, a relatively long working distance of at least several millimeters must be maintained between the specimen and the electron column in order to facilitate collection of secondary electrons by the surrounding electron detectors.

In addition to the measurement methods presented in the aforementioned patent, the signals from the four spatial detectors can be combined using stereoscopic methods described by P. Atkin and K.C.A. Smith in an article entitled "Automatic Stereometry and Special Problems of the SEM", Electron Microscopy and Analysis, Institute of Physics Conference Series Number 68, 1983, pp. 219-222 to provide indirect three dimensional imaging and measurement of the specimen surface.

U.S. Patents 4,728,790 and 4,785,176 disclose an electrostatic-magnetic objective lens which provides both high resolution focussing of the primary beam on the specimen and efficient collection of electrons emitted therefrom. A scintillator detector, placed above the objective lens, generates a signal which is proportional to the total electron emission from the specimen. In this prior art, there is no provision for spatial discrimination using multiple detectors, nor is there a provision for separate detection of secondary and backscattered electrons.

U.S. Patent 4,896,036 discloses a detector objective for scanning microscopes consisting of a purely electrostatic objective lens and an annular detector placed above the objective lens. This arrangement has the advantage of preserving the spatial orientation of the detected electrons, by eliminating the Larmor rotation that generally occurs in magnetic objectives. However, electrostatic objectives are known to have large chromatic aberrations, which limit their resolution at low primary beam energies. This is a disadvantage in semiconductor applications, for which low beam energies are needed to avoid specimen charging and damage.

There is therefore a need for particle beam column which provides very high resolution topographic and/or material feature discrimination of a specimen.

### SUMMARY OF THE PRESENT INVENTION

The present invention is for a particle beam column which provides very high resolution topographic and/or material feature discrimination of a specimen.

Hence, according to the teachings of the present invention, there is provided, a particle beam column for high-resolution imaging and measurement of topographic and material features on a specimen, the particle beam column comprising: (a) a particle source for providing a primary beam along a primary beam axis, the primary beam impinging on the specimen so as to release electrons therefrom, the electrons including secondary electrons and backscattered electrons; (b) an objective lens for focussing the electrons so as to provide a radial dispersion of the electrons relative to the primary beam axis, the radial dispersion of electrons including an inner annulus of backscattered electrons and an outer annulus of secondary electrons; (c) a backscattered electron detector for detecting the inner annulus of backscattered electrons, the backscattered electron detector being located between the particle source and the objective lens; and (d) a secondary electron detector for detecting the outer annulus of secondary electrons, the secondary electron detector being located between the particle source and the objective lens.

According to a further feature of the present invention, the objective lens includes an electrostatic objective lens.

According to a still further feature of the present invention, the objective lens includes a magnetic objective lens.

According to a yet still further feature of the present invention, the objective lens includes an electrostatic objective lens and a magnetic objective lens, the electrostatic objective lens deployed between the specimen and the magnetic objective lens so as to preserve the angular orientation of the secondary electrons.

According to a yet still further feature of the present invention, the secondary electron detector and the backscattered electron detector are realized as a single electron detector.

According to a yet still further feature of the present invention, the backscattered electron detector is deployed above the secondary electron detector relative to the specimen.

According to a yet still further feature of the present invention, the backscattered electron detector is annular.

According to a yet still further feature of the present invention, the secondary electron detector is split into angular sectors so as to provide pairs of signals for linewidth measurements of topographic features.

According to a yet still further feature of the present invention, the secondary electron detector can distinguish topographic features which protrude from the specimen from those which are recessed into the specimen.

According to a yet still further feature of the present invention, electric potentials are applied to the surface of the backscattered electron detector so as to increase the acceptance of backscattered electrons close to the primary beam axis.

According to a yet still further feature of the present invention, further comprising a beam shield tube having a flange constructed in a geometrical shape and of a material so as to increase the acceptance of backscattered electrons close to the primary beam axis.

### BRIEF DESCRIPTION OF THE DRAWINGS

These and further constructional features of the invention will be appreciated in the light of the ensuing description of a preferred embodiment thereof, given by way of example only with reference to the accompanying drawings, wherein:
FIG. 1 is a schematic view of a preferred embodiment of a particle beam column, constructed and operative according to the teachings of the present invention, for enabling both high resolution imaging and measurement of topographic features and material features on a specimen;
FIG. 2 is a schematic view illustrating the trajectories of secondary electrons (SEs) and backscattered electrons (BSEs) as they travel from the specimen to their respective electron detectors deployed within the particle beam column;
FIG. 3 is a schematic view of a preferred embodiment of the electron detector included in the particle beam column of Figure 1;
FIG. 4 is a graph illustrating the angular distribution of secondary electrons emitted from a topographic feature on the specimen;
FIG. 5 is a graph illustrating the radial distribution of secondary and backscattered electrons at the detector plane of the particle beam column of Figure 1; and
FIG. 6 is a schematic view of a second embodiment of a particle beam column for enabling both high resolution imaging and measurement of topographic features and material features on a specimen.

### DESCRIPTION OF THE PREFERRED EMBODIMENT

The present invention is of a particle beam column which enables both high resolution imaging and measurement of topographic features and material features on a specimen.

The principles and operation of the particle beam column according to the present invention may be better understood with reference to the drawings and the accompanying description.

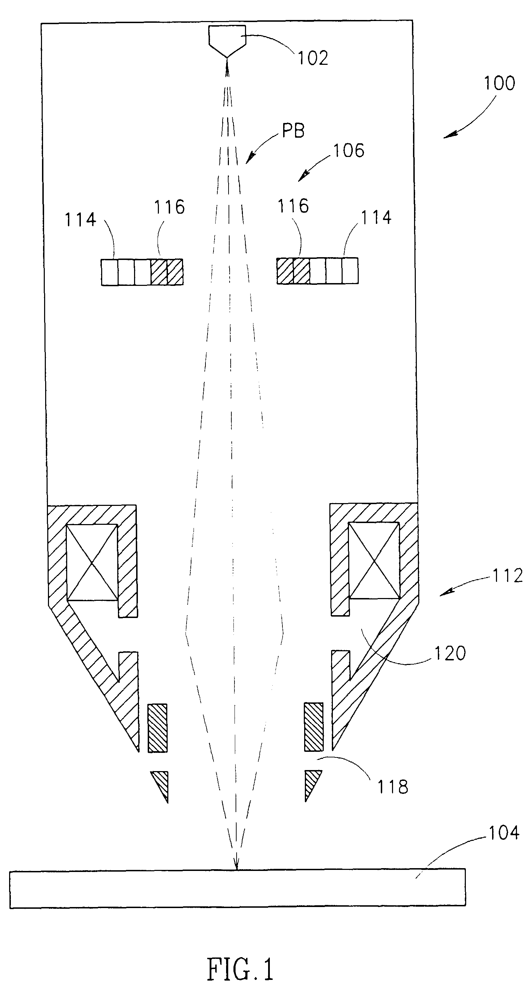

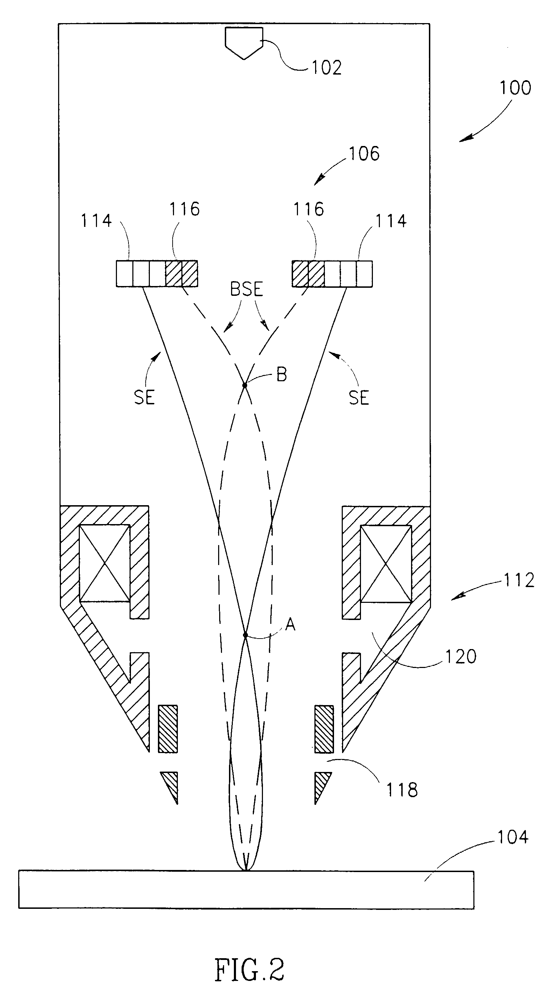

Referring now to the drawings, Figures 1-3 show a preferred embodiment of a particle beam column, generally designated **100**, constructed and operative according to the teachings of the present invention, for enabling high resolution imaging and measurement of both topographic features and material features on a specimen. Generally speaking, this capability is achieved by distinguishing between the secondary electrons (SEs) and the backscattered electrons (BSEs) emitted from a specimen bombarded with a primary beam. This enables the SEs to be employed for high resolution imaging and measurement of topographic features on a specimen and the BSEs to be employed for high resolution imaging and measurement of material features on a specimen. The SEs and the BSEs can be distinguished by their disparate radial dispersion relative to the primary beam axis of the primary beam. The disparate radial dispersal of the SEs and the BSEs is due to the BSEs being more energetic than the SEs.

Particle beam column **100** includes a particle source **102** for scanning the surface of a specimen **104** with a finely focussed primary beam denoted PB. Particle source **102** is preferably a field-emission electron source characterized by a virtual source size of several nanometers and an energy spread of several tenths of an electron volt. Primary beam electrons typically have kinetic energies greater than 200 eVs and travel along a primary beam axis.

Particle beam PB passes through the center of an electron detector **106** including a beam shielding tube **108** with a flange termination **110** formed of conducting and preferably non-magnetic materials and maintained at nearly the same potential as the surrounding column so as to prevent shifting or aberration of primary beam PB as it passes through electron detector **106**. As known in the art, deployment of electron detector **106** inside particle beam column **100** enables the use of a very short working distance between specimen **104** and column **100**. Insofar as aberrations of primary beam PB generally increase with working distance, high resolution and measurement accuracy can be achieved with this configuration.

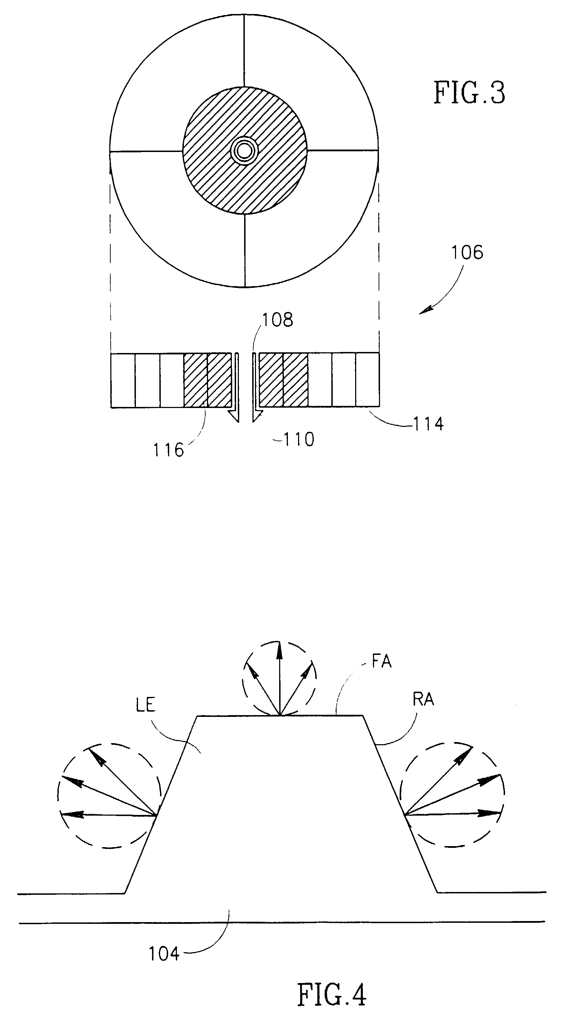

Primary beam electrons cause a release of electrons from the surface of specimen **104** having kinetic energies ranging from zero to the kinetic energy of primary beam PB. The electrons emitted from specimen **104** therefore include both BSEs and SEs. On leaving the specimen, the SEs become spatially separated according to their angles of emission from the different surfaces as described in greater detail with respect to Figure 4.

Turning briefly to Figure 4, in the case that specimen **104** includes a topographic feature having a left edge LE, a flat area FA and a right edge RE, SEs emitted from edges LE and RE are concentrated on the left side and right side, respectively, of the feature whereas SEs emitted from the flat area FA are split more or less equally between the two sides. It should be noted that the circles, which are polar representations of the well-known Lambertian or cosine-law angular distribution for secondary emission, indicate that secondary emission is strongest in the direction perpendicular to the surface. Furthermore, the total emission intensity is greater at edges LE and RE, where primary beam PB enters specimen **104** at grazing incidence, than at flat area FA, thereby explaining the strong correlation between surface topography and secondary electron emission.

The electrons emitted from specimen **104** are focussed by an objective lens, generally designated **112**, causing the SEs to cross over at a SE crossover point A and BSEs to cross over at a BSE crossover point B. As can be readily seen, BSE crossover point B is substantially higher than SE crossover point A relative to specimen **104** due to the BSEs being more energetic than the SEs. After passing through their respective crossover points, the SEs and the BSEs travel toward electron detector **106** along trajectories which are near straight lines in the meridional plane of objective lens **112**.

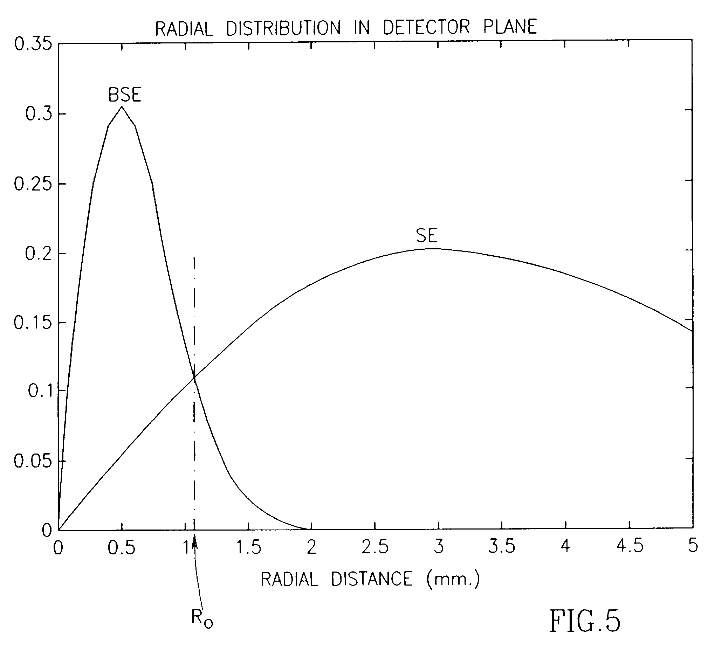

Hence, the radial dispersion of SEs from the primary beam axis at electron detector **106** is greater than that of the BSEs because the distance from SE crossover point A to electron detector **106** is greater than the distance from BSE crossover point B to electron detector **106**. In other words, the radial dispersion of electrons includes an outer annulus of SEs and an inner annulus of BSEs. Thus, in contrast to conventional electron detectors, electron detector **106** includes a secondary electron (SE) detector **114** for detecting the outer annulus of SEs and a backscattered electron (BSE) detector **116** for detecting the inner annulus of BSEs. Efficient separation of SEs and BSEs is achieved by selecting the outer radius of BSE detector **116** to be equal to a value R₀ as depicted in Figure 5.

Objective lens **112** is preferably implemented as the combined electrostatic-magnetic objective lens described U.S. Patent 4,785,176 including an electrostatic objective lens **118** and a magnetic objective lens **120** deployed above electrostatic objective lens **118** relative to specimen **104** for reasons described hereinbelow. As known in the art, such an objective lens enables, on the one hand, the use of a high energy primary beam PB, for example, in the order of about 9000 eVs, thereby minimizing chromatic aberration effects, and on the other hand, the stripping away of most of the energy of the electrons just before their impingement on specimen **104** such that impinging electrons have a relatively low landing energy in the order of about 1000 eVs. However, it should be noted that objective lens **112** can be implemented as an electrostatic objective lens or a magnetic objective lens, although at a lower resolution than the combined electrostatic-magnetic objective lens.

First, electrostatic objective lens **118** of objective lens **112** accelerates the electrons emitted from specimen **104** to kinetic energies of several kiloelectron volts toward electron detector **106**. Then, magnetic objective lens **120** of objective lens **112** rotates the electrons through an angle θ about the primary beam axis as they pass therethrough, the angle θ given by: θ = kB/√U where k is a constant, B is the magnetic field strength, and U is the electron kinetic energy in an action known as a "Larmor rotation".

Because the energy spread of the SEs is only 50 electron volts, which is a small fraction of their total kinetic energies after acceleration by electrostatic objective lens **118**, the SEs rotate through very nearly the same angle. In other words, the SEs rotate as a rigid body about the PB axis, thereby maintaining their topographic ordering which existed in the plane of electrostatic objective lens **118**. In contrast, the BSEs have widely differing kinetic energies and therefore do not rotate as a rigid body. However, this is of no consequence because it is the intensity of the BSEs which conveys material information rather than their angular distribution.

It should be emphasized that interchanging the positions of electrostatic objective lens **118** and magnetic objective lens **120** would lead to destruction of the topographic information carried by the SEs. In this case, the Larmor rotations of SEs differing in energy by a few electron volts would be vastly different, and the angular information would be totally scrambled by propagation through magnetic objective lens **118**.

SE detector **114** and BSE detector **116** are preferably implemented as a single device in which SE detector **114** is preferably split into four sectors as shown in Figure 3 in order to perform linewidth measurements in the manner described in U.S. Patent 4,941,980 and BSE detector **116** is implemented as an annular ring. Therefore, electron detector **106** provides five output signals simultaneously, in series or parallel, corresponding to four spatial SE signals and one BSE signal. All in all, these signals can provide a material image and one or more topographic images. Alternatively, the images can be overlayed by known stereoscopic methods to provide a three-dimensional topographic image with color shading to indicate material composition.

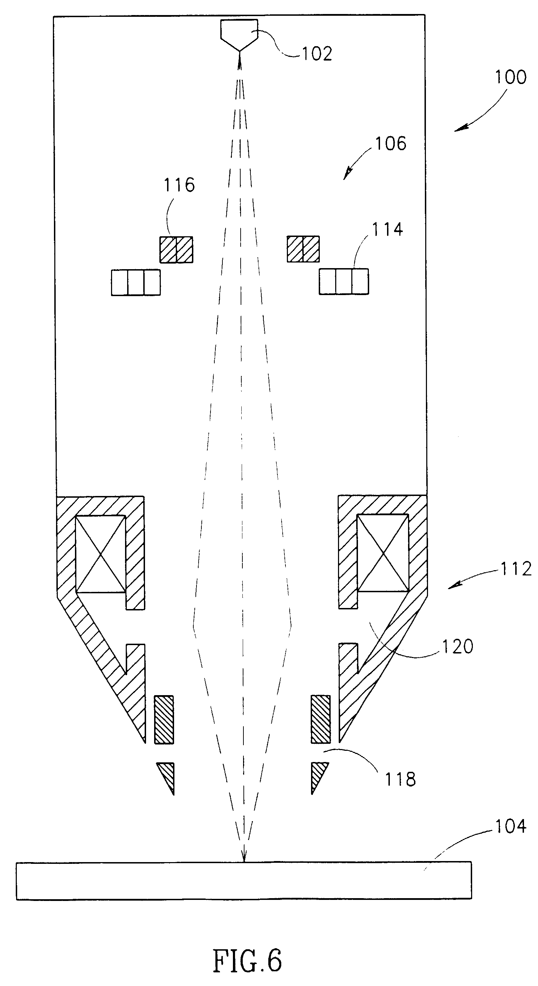

It should be noted that the number of sectors of SE detector **114** can be less than, equal to, or greater than four, depending upon the orientations of features in the plane of specimen **104** and the required degree of spatial discrimination. Furthermore, SE detector **114** and BSE detector **116** can be implemented as discrete devices as shown in Figure 6. This design has the advantage of enabling independent gain adjustment of SE detector **114** and BSE detector **116** and of permitting separate replacement of the detectors for maintenance.

Both SE and BSE detectors **114** and **116** can be readily fabricated using existing technology for scintillator, solid-state or microchannel plate electron detectors. It should be noted that the sectors of SE detector **114** and the annular ring of BSE detector **116** can be formed in either a physical or an electronic manner. For example, a microchannel plate electron detector can be fabricated with physical regions on its collecting anode which correspond to those shown in Figure 3. Alternatively, a position-sensitive microchannel plate electron detector can be used, in which the position of each electron hitting the surface of the detector is measured electronically. In this case, impacts would be counted in each sector of SE detector **114** and in the annular ring of BSE detector **116** using analog or digital accumulators. Alternatively, the sectors of SE detector **114** and the annular ring of BSE detector **116** could be fabricated from discrete devices, such as Everhart-Thornley scintillator electron detectors. In either physical or electronic implementations, the principle of angular discrimination of the SEs and the principle of radial separation of SEs and BSEs remain the same.

When imaging and measuring deep surface structures, such as trenches and contact holes, in semiconductor wafers, the detection of near-axial BSEs is preferably enhanced by applying the teachings of pending U.S. Patent Application Serial No. 08/262,285. This is achieved forming flange termination **110** from material which facilitates the generation of secondary electrons by impacting BSEs and applying potentials to the active surfaces of BSE detector **116** and flange termination **110** so as to efficiently collect these SEs, as fully set forth in US Patent No. 5,466,940.

While the invention has been described with respect to a limited number of embodiments, it will be appreciated that many variations, modifications and other applications of the invention can be made.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A particle beam column (100) for high-resolution imaging and measurement of topographic and material features on a specimen (104), the particle beam column comprising:
(a) a particle source (102) for providing a primary beam (PB) along a primary beam axis, said primary beam impinging on the specimen so as to release electrons therefrom, said electrons including secondary electrons (SE) and backscattered electrons (BSE);
(b) an objective lens (112) for focussing said electrons so as to provide a radial dispersion of said electrons relative to said primary beam axis, said radial dispersion of electrons including an inner annulus of backscattered electrons and an outer annulus of secondary electrons;
(c) a backscattered electron detector (116) for detecting said inner annulus of backscattered electrons, said backscattered electron detector being located between said particle source and said objective lens; and
(d) a secondary electron detector (114) for detecting said outer annulus of secondary electrons, said secondary electron detector being located between said particle source and said objective lens.

2. The particle beam column as in claim 1 wherein said objective lens (112) includes an electrostatic objective lens (118).

3. The particle beam column as in claim 1 wherein said objective lens (112) includes a magnetic objective lens (120).

4. The particle beam column as in claim 1 wherein said objective lens includes an electrostatic objective lens (118) and a magnetic objective lens (120), said electrostatic objective lens deployed between the specimen and said magnetic objective lens so as to preserve the angular orientation of the secondary electrons.

5. The particle beam column as in claim 1 wherein said secondary electron detector and said backscattered electron detector are realized as a single electron detector (106).

6. The particle beam column as in claim 1 wherein said backscattered electron detector (116) is deployed above said secondary electron detector (114) relative to the specimen.

7. The particle beam column as in claim 1 wherein said backscattered electron detector (116) is annular.

8. The particle beam column as in claim 1 wherein said secondary electron detector (114) is split into angular sectors so as to provide pairs of signals for linewidth measurements of topographic features.

9. The particle beam column as in claim 8 wherein said secondary electron detector (114) is split into angular sectors so as to distinguish topographic features which protrude from the specimen from those which are recessed into the specimen.

## Patentansprüche

1. Eine Partikelstrahlsäule (100) zur hochauflösenden Abbildung und Erfassung von topographischen Eigenschaften und Materialeigenschaften einer Probe (104), wobei die Partikelstrahlsäule folgendes enthält:
(a) eine Partikelquelle (102) zum Bereitstellen eines Primärstrahls (PB) entlang einer Primärstrahlachse, wobei der Primärstrahl auf die Probe derart einfällt, daß sie Elektronen davon freisetzt, wobei die Elektronen Sekundärelektronen (SE) und Rückstreuelektronen (BSE) umfassen;
(b) eine Objektivlinse (112), um die Elektronen derart zu fokussieren, daß eine radiale Streuung der Elektronen in bezug auf die Primärstrahlachse bereitgestellt wird, wobei die radiale Streuung von Elektronen einen Innenkreisring von Rückstreuelektronen und einen Außenkreisring von Sekundärelektronen umfaßt;
(c) einen Rückstreuelektronen-Detektor (116) zum Erfassen des Innenkreisringes von Rückstreuelektronen, wobei sich der Rückstreuelektronen-Detektor zwischen der Partikelquelle und der Objektivlinse befindet; und
(d) einen Sekundärelektronen-Detektor (114) zum Erfassen des Außenkreisringes von Sekundärelektronen, wobei sich der Sekundärelektronen-Detektor zwischen der Partikelquelle und der Objektivlinse befindet.

2. Die Partikelstrahlsäule gemäß Anspruch 1, worin die Objektivlinse (112) eine elektrostatische Objektivlinse (118) umfaßt.

3. Die Partikelstrahlsäule gemäß Anspruch 1, worin die Objektivlinse (112) eine magnetische Objektivlinse (120) umfaßt.

4. Die Partikelstrahlsäule gemäß Anspruch 1, worin die Objektivlinse eine elektrostatische Objektivlinse (118) und eine magnetische Objektivlinse (120) umfaßt, wobei die elektrostatische Objektivlinse zwischen der Probe und der magnetischen Objektivlinse angebracht ist, um die winkelmäßige Ausrichtung der Sekundärelektronen beizubehalten.

5. Die Partikelstrahlsäule gemäß Anspruch 1, worin der Sekundärelektronen-Detektor und der Rückstreuelektronen-Detektor als ein einziger Elektronendetektor (106) verwirklicht sind.

6. Die Partikelstrahlsäule gemäß Anspruch 1, worin der Rückstreuelektronen-Detektor (116) oberhalb des Sekundärelektronen-Detektors (114) in bezug auf die Probe angebracht ist.

7. Die Partikelstrahlsäule gemäß Anspruch 1, worin der Rückstreuelektronen-Detektor (116) kreisförmig ist.

8. Die Partikelstrahlsäule gemäß Anspruch 1, worin der Sekundärelektronen-Detektor (114) in Winkelabschnitte aufgeteilt ist, um Signalpaare für Linienstärken-Erfassungen von topographischen Eigenschaften bereitzustellen.

9. Die Partikelstrahlsäule gemäß Anspruch 8, worin der Sekundärelektronen-Detektor (114) in Winkelabschnitte aufgeteilt ist, um die topographischen Eigenschaften, die sich von der Probe erstrecken, von jenen zu unterscheiden, die in der Probe eingelassen sind.

## Revendications

1. Colonne de faisceau de particules (100) pour la formation d'image et la mesure à haute résolution de caractéristiques topographiques et matérielles sur un spécimen (104), la colonne de faisceau de particules comprenant :
(a) une source de particules (102) pour fournir un faisceau primaire (PB) le long d'un axe de faisceau primaire, ledit faisceau primaire frappant le spécimen de façon à en libérer des électrons, lesdits électrons comprenant des électrons secondaires (SE) et des électrons rétrodiffusés (BSE);
(b) une lentille d'objectif (112) pour focaliser les électrons de façon à fournir une dispersion radiale desdits électrons par rapport audit axe de faisceau primaire, ladite dispersion radiale des électrons comprenant une couronne intérieure d'électrons rétrodiffusés et une couronne extérieure d'électrons secondaires;
(c) un détecteur d'électron rétrodiffusé (116) pour détecter ladite couronne intérieure d'électrons rétrodiffusés, ledit détecteur d'électron rétrodiffusé étant situé entre ladite source de particules et ladite lentille d'objectif; et
(d) un détecteur d'électron secondaire (114) pour détecter ladite couronne extérieure d'électrons secondaires, ledit détecteur d'électron secondaire étant situé entre ladite source de particules et ladite lentille d'objectif.

2. Colonne de faisceau de particules selon la revendication 1 dans laquelle ladite lentille d'objectif (102) comprend une lentille d'objectif électrostatique (118).

3. Colonne de faisceau de particules selon la revendication 1 dans laquelle ladite lentille d'objectif (112) comprend une lentille d'objectif magnétique (120).

4. Colonne de faisceau de particules selon la revendication 1 dans laquelle ladite lentille d'objectif comprend une lentille d'objectif électrostatique (118) et une lentille d'objectif magnétique (120), ladite lentille d'objectif électrostatique étant déployée entre le spécimen et ladite lentille d'objectif magnétique de façon à préserver l'orientation angulaire des électrons secondaires.

5. Colonne de faisceau de particules selon la revendication 1 dans laquelle ledit détecteur d'électron secondaire et ledit détecteur d'électron rétrodiffusé sont réalisés sous la forme d'un détecteur d'électron unique (106).

6. Colonne de faisceau de particules selon la revendication 1 dans laquelle ledit détecteur d'électrpn rétrodiffusé (116) est déployé au-dessus dudit détecteur d'électron secondaire (114) par rapport au spécimen.

7. Colonne de faisceau de particules selon la revendication 1 dans laquelle ledit détecteur d'électron rétrodiffusé (116) est annulaire.

8. Colonne de faisceau de particules selon la revendication 1 dans laquelle ledit détecteur d'électron secondaire (114) est divisé en secteurs angulaires de façon à fournir des paires de signaux pour des mesures de largeur de ligne de caractéristiques topographiques.

9. Colonne de faisceau de particules selon la revendication 8 dans laquelle ledit détecteur d'électron secondaire (114) est divisé en secteurs angulaires de façon à distinguer les caractéristiques topographiques qui font saillie du spécimen de celles qui sont en creux dans le spécimen.
